(19) Europäisches Patentamt
European Patent Office
Office européen des brevets

(11) **EP 3 877 326 B1**

(12) **FASCICULE DE BREVET EUROPEEN**

(45) Date de publication et mention de la délivrance du brevet:
**10.04.2024 Bulletin 2024/15**

(21) Numéro de dépôt: **19778991.0**

(22) Date de dépôt: **27.09.2019**

(51) Classification Internationale des Brevets (IPC):
***B81B 7/00*** *(2006.01)*

(52) Classification Coopérative des Brevets (CPC):
**B81B 7/0038; B81B 7/0067;** B81B 2201/0207;
B81B 2201/047

(86) Numéro de dépôt international:
**PCT/EP2019/076186**

(87) Numéro de publication internationale:
**WO 2020/094292 (14.05.2020 Gazette 2020/20)**

(54) **BOITIER HERMETIQUE COMPORTANT UN GETTER, COMPOSANT OPTOELECTRONIQUE OU DISPOSITIF MEMS INTEGRANT UN TEL BOITIER HERMETIQUE ET PROCEDE DE FABRICATION ASSOCIE**

HERMETISCHES GEHÄUSE MIT EINEM GETTER, OPTOELEKTRONISCHES BAUELEMENT ODER MEMS-VORRICHTUNG MIT EINEM SOLCHEN HERMETISCHEN GEHÄUSE UND ZUGEHÖRIGES HERSTELLUNGSVERFAHREN

HERMETIC HOUSING COMPRISING A GETTER, OPTOELECTRONIC COMPONENT OR MEMS DEVICE INCORPORATING SUCH A HERMETIC HOUSING AND ASSOCIATED PRODUCTION METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.11.2018 FR 1860267**

(43) Date de publication de la demande:
**15.09.2021 Bulletin 2021/37**

(72) Inventeurs:
* **LEMETTRE, Sylvain**
  **91300 Massy (FR)**
* **BUNEL, David**
  **38430 Moirans (FR)**
* **MOULIN, Johan**
  **92160 Antony (FR)**
* **BOSSEBOEUF, Alain**
  **91300 Massy (FR)**

(73) Titulaires:
* **LYNRED**
  **91120 Palaiseau (FR)**
* **Université Paris-Saclay**
  **91190 Saint-Aubin (FR)**
* **Centre National de la Recherche Scientifique**
  **75016 Paris 16 (FR)**

(74) Mandataire: **Cabinet Laurent & Charras**
**Le Contemporain**
**50 Chemin de la Bruyère**
**69574 Dardilly Cedex (FR)**

(56) Documents cités:
**EP-A1- 2 537 797      US-A1- 2007 205 720**
**US-A1- 2015 014 854**

## Description

### DOMAINE TECHNIQUE

L'invention concerne un boîtier hermétique configuré pour former une enceinte au sein de laquelle règne une pression prédéterminée, et destinée à recevoir un composant, dont le fonctionnement nécessite une faible pression ou le vide. L'invention concerne également un composant optoélectronique ou un dispositif MEMS encapsulé dans un tel boîtier hermétique. Elle concerne enfin un procédé de réalisation d'un tel boîtier hermétique.

L'invention peut être mise en oeuvre pour tout type de composant optoélectronique ou de dispositif MEMS pour lequel une enceinte avec une pression prédéterminée est requise, par exemple pour les bolomètres d'imagerie.

### ART ANTERIEUR

Afin de former un boîtier sous vide ou sous pression réduite, il est connu d'utiliser un pompage de l'air dans une enceinte, suivi par le scellement des parois constitutives du boîtier, notamment par soudure métallique. Cependant, réaliser une soudure métallique engendre un échauffement de l'enceinte, entrainant la désorption des molécules de gaz piégées sur les parois de l'enceinte.

Lorsque le boîtier est scellé, les gaz présents dans le boîtier ne peuvent plus être évacués par le système de pompage, de sorte qu'un dispositif spécifique d'absorption doit être positionné au sein du boîtier pour éliminer les gaz résultants de la désorption des parois et présents au sein dudit boîtier. Ce dispositif d'absorption est appelé « getter ».

Un getter se présente classiquement sous la forme d'une couche métallique déposée sur l'une des parois du boîtier. Le getter est initialement passivé. Cette passivation est réalisée par son oxyde natif s'il a été exposé à l'air ambiant ou par une couche de métal noble recouvrant le getter ou par un oxyde résultant d'un traitement thermique particulier.

Il est donc nécessaire d'activer le getter de sorte à provoquer une dissolution de l'oxyde natif ou de la couche de métal noble dans le volume de la couche métallique, rendant alors le getter réactif.

Cette activation est traditionnellement réalisée par chauffage du getter. Suite à ce chauffage, les atomes de la couche de passivation diffusent dans la couche métallique du getter, et la surface de la couche métallique est apte à capter les gaz présents dans le boîtier, abaissant ainsi la pression en son sein. Le getter est alors dit « activé ».

Le niveau de vide atteint dans une enceinte est contrôlé par la quantité de molécules gazeuses absorbées par le getter. Cette quantité dépend des conditions d'activation et des propriétés du getter, c'est-à-dire de sa nature chimique, de sa microstructure et de l'étendue de sa surface au contact des gaz de l'enceinte.

En ce qui concerne les conditions d'activation du getter, il est recherché une diffusion des atomes de la couche de passivation dans le volume du getter. Pour faciliter cette diffusion, le getter doit présenter une haute densité de joints de grains, car la diffusion est plus rapide à travers les joints de grains que dans l'intérieur des grains. En outre, au cours de l'activation, la quantité de gaz désorbée est croissante avec la température de recuit. Ainsi, avec une haute densité de joints de grains, il est possible de limiter la température d'activation du getter et, ainsi, de limiter la désorption des molécules de gaz dans l'enceinte pour obtenir une pression très faible.

Dans le même temps, il est également connu qu'un getter insuffisamment épais ne peut pas régénérer le caractère métallique de sa surface, car les atomes d'impuretés constituant la couche de passivation ne peuvent pas diffuser à l'intérieur du getter. Par exemple, le document US 7,998,319 indique que les propriétés d'absorption d'un getter sont réduites lorsque l'épaisseur du getter est inférieure à 500 nanomètres. De même, le document US 6,897,551 indique que les propriétés d'absorption d'un getter sont excessivement réduites lorsque l'épaisseur du getter est inférieure à 100 nanomètres.

Ainsi, pour répondre efficacement aux contraintes des conditions d'activation et des besoins d'absorption, il est préférable d'utiliser une couche de matériau getter avec une épaisseur suffisante, typiquement avec une épaisseur supérieure à 60 nanomètres.

En outre, la quantité de gaz absorbé dépend de la surface du matériau getter à l'intérieur de l'enceinte. Dans le cas d'un composant optoélectronique, le boîtier comporte une fenêtre optique transparente pour au moins une longueur d'onde d'intérêt du composant optoélectronique.

La présence de cette fenêtre optique réduit généralement la surface utile pour déposer le matériau getter sur les parois internes du boîtier. En effet, tel que décrit dans le document US 8,395,229, il est classique de ne pas déposer le matériau getter sur la fenêtre optique, car la présence du matériau getter peut dégrader la qualité du signal optique transmis à travers la fenêtre optique. Ainsi, tel que décrit dans le document US2014/0175590, les boîtiers des composants optoélectroniques fonctionnant sous vide sont classiquement surdimensionnés pour permettre le positionnement du matériau getter sur une partie du boîtier différente de la fenêtre optique.

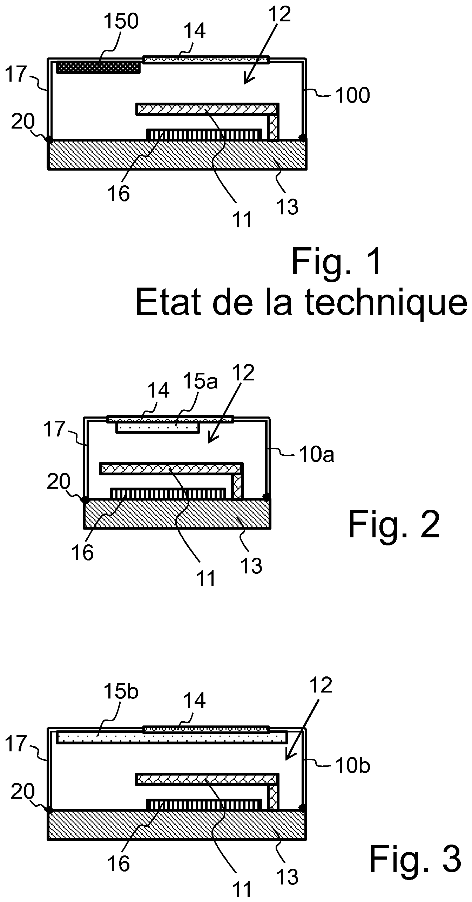

Tel qu'illustré sur la figure 1 de l'état antérieur de la technique, un composant optoélectronique **11** est classiquement encapsulé dans une enceinte **12** sous une pression prédéterminée, par exemple sous une pression inférieure à $10^{-3}$ mbar. L'enceinte **12** est formée par le scellement de parois **17** sur un substrat **13** au moyen d'un joint de scellement métallique **20,** formant ainsi un boîtier hermétique **100** autour du composant **11.**

Pour permettre au composant optoélectronique **11** de capter les rayonnements externes, une paroi supérieure du boîtier **100** est conformée pour présenter une fenêtre optique **14**. Par exemple, cette fenêtre optique **14** peut être réalisée par des structures de type « *Moth-Eyes* », tel que décrit dans le document EP 2 613 181. En outre, les rayonnements externes peuvent également être redirigés sur la face arrière du composant optoélectronique **11** au moyen d'un réflecteur **16**, lorsque le composant optoélectronique **11** est monté en suspension sur le substrat **13**, par exemple dans le cas d'un bolomètre d'imagerie non refroidi.

La taille du boîtier **100** est bien supérieure aux dimensions du composant optoélectronique **11** de sorte à permettre le positionnement d'un matériau getter **150** à côté de la fenêtre optique **14**.

A contre-courant de cette technique de positionnement classique, l'invention vise à obtenir un boîtier avec un matériau getter déposé sur la fenêtre optique afin de réduire la dimension du boîtier par rapport à la dimension du composant optoélectronique ou d'augmenter la surface du matériau getter.

Il est connu du document US 7,789,949 d'utiliser un getter très fin sur un substrat transparent aux rayonnements. Pour limiter l'influence de la présence du matériau getter sur la transmission du signal optique, ce document préconise l'utilisation d'un film getter dont l'épaisseur est inférieure à 60 nanomètres. Plus précisément, il est indiqué que des résultats satisfaisants ont été obtenus avec un film getter dont l'épaisseur est inférieure à 30 nanomètres.

Tel que décrit précédemment, l'épaisseur du matériau getter du document US 7,789,949 ne permet pas toujours de répondre efficacement aux contraintes des conditions d'activation et des besoins d'absorption car l'épaisseur du matériau getter est trop faible.

Le document US 2015/0014854 divulgue un getter périphérique sur la région de liaison d'un capot relié à un substrat pour former une cavité hermétique pour un dispositif optoélectronique. Le getter est poreux et présente une épaisseur supérieure à 100 nanomètres.

Le problème technique objectif de l'invention est de fournir un boîtier hermétique avec une couche de matériau getter, déposée sur une fenêtre optique, dont la microstructure permet de répondre plus efficacement aux contraintes des conditions d'activation et des besoins d'absorption tout en permettant une transmission efficace du signal optique.

**EXPOSE DE L'INVENTION**

Pour répondre à ce problème technique, l'invention propose de déposer une couche de matériau getter dont l'épaisseur est d'au moins 60 nanomètres, et dont la porosité est comprise entre 10% et 70% de sorte à laisser passer une fraction suffisante du signal optique. L'invention concerne plus particulièrement la mise en oeuvre d'une relation permettant de déterminer la manière de régler l'épaisseur et la porosité pour obtenir un getter efficace tout en limitant l'impact sur le signal optique en fonction de la nature du matériau getter, c'est-à-dire en fonction de son coefficient d'absorption et de son coefficient d'extinction.

A cet effet, selon un premier aspect, l'invention concerne un boîtier hermétique pour composant optoélectronique ou dispositif MEMS configuré pour former une enceinte au sein de laquelle règne une faible pression ou le vide, ledit boîtier hermétique comportant :

- une fenêtre optique transparente pour au moins une longueur d'onde d'intérêt dudit composant optoélectronique ou dudit dispositif MEMS ; et
- une couche de matériau getter configurée pour capter des gaz présents dans ladite enceinte, ladite couche étant déposée sur la fenêtre optique en regard de ladite enceinte.

L'invention se caractérise en ce que la couche de matériau getter comporte une épaisseur $e_t$, supérieure à 60 nanomètres, et une porosité P comprise entre 10% et 70%, l'épaisseur $e_t$ et la porosité P étant configurées de sorte à satisfaire la relation suivante :

$$(1 - P) * e_t < \frac{\lambda}{2\pi k}$$

avec :

- $\lambda$ correspondant à ladite au moins longueur d'onde d'intérêt de la fenêtre optique, et
- k correspondant au coefficient d'extinction du matériau de ladite couche de matériau getter pour ladite au moins longueur d'onde d'intérêt de la fenêtre optique.

Dans cette équation :

- l'expression $(1 - P) * e_t$ représente l'épaisseur équivalente de matière traversée par un rayon lumineux ;
- l'expression $\frac{\lambda}{2\pi k}$ représente l'épaisseur maximale que peut traverser le rayon lumineux avant d'être considéré comme atténué. Cette expression fait référence au coefficient d'extinction du matériau massif. Ce coefficient d'extinction peut être trouvé dans différentes publications en fonction de la longueur d'onde considérée. Par exemple, en utilisant le modèle de Brendel-Bormann de 1998, le coefficient d'extinction du titane est de 14.628 pour une longueur d'onde de 8 micromètres et de 23.941 pour une longueur d'onde de 14 micromètres. Le modèle de Lorentz-Drude de 1998 donne quant à lui des coefficients d'extinction du titane de 14.794 et 24.007 pour les deux longueurs d'onde considérées.

En outre, ce coefficient d'extinction est directement lié au coefficient d'atténuation α du matériau considéré par la relation suivante :

$$k = \alpha . \frac{\lambda}{4\pi}$$

Ce coefficient d'atténuation peut également être trouvé dans des publications du type de celles précédemment indiquées.

L'invention permet ainsi de régler l'épaisseur et la porosité pour obtenir un getter efficace tout en limitant l'impact sur le signal optique. En effet, si la porosité est trop importante, typiquement supérieure à 70%, les parois du getter ne sont plus suffisamment épaisses pour réaliser une absorption des molécules présentes dans l'enceinte. Au contraire, si la porosité est trop faible, typiquement inférieure à 10%, le getter se présente sous la forme d'un matériau massif, et son épaisseur est trop importante pour garantir une transmittance efficace au niveau de la fenêtre optique dans la longueur d'onde d'intérêt. Pour garantir la transmittance, la relation liant la porosité à l'épaisseur doit être inférieure à $\frac{\lambda}{2\pi k}$ .

Classiquement, les pores du matériau getter sont constitués de vide et d'air, mais dans le cadre de l'invention ils peuvent aussi être constitués de tout autre matériau transparent pour ladite au moins une longueur d'onde d'intérêt. Par exemple, les pores peuvent être du silicium, si les longueurs d'onde d'intérêt sont les radiations infrarouge (8-14 μm).

Au sens de l'invention, la porosité P correspond au rapport entre le poids du matériau getter mis en oeuvre dans l'invention et le poids d'un volume massique du même matériau correspondant au volume dudit matériau getter. Ainsi, pour déterminer la porosité d'une couche de matériau getter, il convient de déterminer la nature du matériau getter et de mesurer le volume et le poids de la couche de matériau getter. Ensuite, la nature du matériau getter peut être utilisée pour réaliser une nouvelle couche de matériau massique avec un volume correspondant au volume mesuré. En mesurant le poids de cette couche de matériau massique, il est possible de déterminer la porosité en divisant le poids de la couche de matériau getter avec le poids de la couche de matériau massique.

Il s'ensuit qu'il est possible de dimensionner le boîtier au plus proche des dimensions du composant optoélectronique ou du dispositif MEMS, car il n'est plus nécessaire d'utiliser une portion du boîtier distante de la fenêtre optique pour disposer la couche de matériau getter. En variante, en utilisant un boîtier de taille classique, il est possible d'augmenter la surface de la couche de matériau getter et, ainsi, d'abaisser la pression dans l'enceinte après activation du getter.

Pour augmenter la surface de contact du getter avec les gaz présents dans l'enceinte, la couche de matériau getter peut présenter une base surmontée par un motif de structuration, l'épaisseur de ladite base étant supérieure à 60 nanomètres.

Dans ce mode de réalisation, l'épaisseur de la base garantit l'absorption des molécules de la couche de passivation (oxyde natif) lors de l'activation du getter et le motif de structuration permet d'augmenter le volume de gaz capté par le getter.

Typiquement, la couche de matériau getter peut être configurée pour garantir une pression inférieure à $10^{-3}$ mbar dans l'enceinte.

Ce mode de réalisation permet d'atteindre une sensibilité maximale pour les bolomètres d'imagerie, et en particulier pour les micro-bolomètres non refroidis dans le domaine de l'imagerie infrarouge.

La couche de matériau getter peut être réalisée en zirconium, en titane, en vanadium, en hafnium, en niobium, en tantale, en cobalt, en yttrium, en baryum, en fer ou en alliage de ces matériaux. De plus, du chrome (Cr), de l'aluminium (Al), du nickel (Ni) et des terres rares telles que le cérium (Ce), le césium (Cs) ou le lanthane (La) peuvent être ajoutés à ces métaux pour améliorer les caractéristiques du getter, telles que la taille des grains, l'enthalpie libre de formation des oxydes ou l'activité catalytique pour le craquage des molécules gazeuses.

Ces métaux permettent d'obtenir les propriétés d'absorption recherchées. Bien entendu, l'invention n'est pas limitée à l'utilisation de ces matériaux et tous les métaux de transition, plus le baryum et l'aluminium, peuvent être utilisés comme getter.

Ce mode de réalisation permet à la surface du matériau getter d'avoir un caractère réactif avec les molécules gazeuses, de conserver ce caractère réactif après chimisorption desdites molécules gazeuses, et d'obtenir une surface avec une microstructure favorable à l'absorption des gaz dans l'enceinte.

Selon un second aspect, l'invention concerne un composant optoélectronique ou un dispositif MEMS comportant un boîtier hermétique selon le premier aspect de l'invention.

Selon un troisième aspect, l'invention concerne un procédé de fabrication d'un composant optoélectronique ou d'un dispositif MEMS selon le second aspect de l'invention, ledit procédé comportant une étape de dépôt par évaporation ou pulvérisation d'une couche de matériau getter réalisée sous incidence de ladite fenêtre optique par rapport à un flux généré par un élément d'évaporation ou de pulvérisation de ladite couche de matériau getter.

La méthode de dépôt d'une couche de matériau getter est classiquement réalisée par évaporation ou par pulvérisation avec un flux incident d'atomes déposés selon un angle normal à la surface de dépôt.

Si l'angle entre la surface de dépôt et la normale au flux généré par l'élément d'évaporation ou de pulvérisation est suffisamment important, typiquement entre 40 et 80°, il se produit un effet d'ombrage du flux d'atomes incidents par les germes déposés, conduisant à la croissance de films colonnaires nano-structurés, de grande surface effective. Ainsi, la réalisation d'un dépôt sous incidence permet de régler la porosité de la couche de matériau getter en fonction des besoins recherchés.

En outre, la surface de dépôt peut être déplacée en rotation lors du dépôt de sorte à modifier la structure des films colonnaires nano-structurés. Il s'ensuit qu'il est possible de régler la porosité de la couche de matériau getter en faisant varier l'angle d'incidence du flux d'atomes, la vitesse de rotation de la surface de dépôt et, dans le cas d'un dépôt avec la technique de pulvérisation cathodique, de la pression du gaz porteur. Ces différents paramètres permettent d'obtenir des structures colonnaires variés, telles que des piliers, des zigzags, des spirales carrées ou des hélices.

## DESCRIPTION SOMMAIRE DES FIGURES

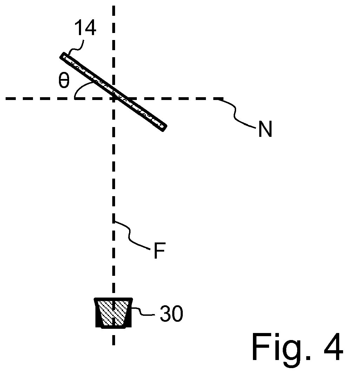

La manière de réaliser l'invention ainsi que les avantages qui en découlent, ressortiront bien des modes de réalisation qui suivent, donnés à titre indicatif mais non limitatif, à l'appui des figures annexées dans lesquelles les figures 1 et 4 représentent :

- Figure 1 - état de la technique : représentation schématique en section d'un composant optoélectronique encapsulé dans un boîtier dans lequel un getter est disposé sur une paroi supérieure de l'enceinte à côté d'une fenêtre optique ;
- Figure 2 : représentation schématique en section d'un composant optoélectronique encapsulé dans un boîtier selon un premier mode de réalisation de l'invention dans lequel le getter est disposé uniquement sur une fenêtre optique ;
- Figure 3 : représentation schématique en section d'un composant optoélectronique encapsulé dans un boîtier selon un second mode de réalisation de l'invention dans lequel le getter est disposé sur une paroi supérieure de l'enceinte et sur une fenêtre optique ; et
- Figure 4 : représentation schématique d'une étape de dépôt sous incidence du getter de la figure 2.

## DESCRIPTION DETAILLEE DE L'INVENTION

Dans la suite de la description, l'invention sera décrite en référence à un composant optoélectronique **11** bien que l'invention puisse également s'appliquer à un dispositif MEMS sans changer l'invention.

La figure 2 illustre un composant optoélectronique **11** encapsulé dans une enceinte **12** sous une pression prédéterminée, par exemple sous une pression inférieure à $10^{-3}$ mbar. L'enceinte **12** est formée par le scellement de parois **17** sur un substrat **13** au moyen d'un joint de scellement métallique **20**, formant ainsi un boîtier hermétique **10a** autour du composant optoélectronique **11.**

L'invention est décrite en considérant que le composant optoélectronique **11** correspond à un micro-bolomètre monté en suspension sur un substrat **13**. En variante, d'autres composants optoélectroniques **11** destinés à fonctionner dans une atmosphère contrôlée peuvent être utilisés sans modifier la portée de l'invention.

Le micro-bolomètre **11** présente une membrane bolométrique disposée en suspension sur le substrat **13**. Cette membrane bolométrique est configurée pour capter les rayonnements infrarouges avec une longueur d'onde comprise entre 8 et 14 micromètres.

Les rayonnements infrarouges sont transmis depuis l'extérieur du boîtier et filtrés par une fenêtre optique **14** de sorte à filtrer les rayonnements dont la longueur d'onde est inférieure à 8 micromètres, car ces longueurs d'ondes éblouiraient le micro-bolomètre **11**.

Par exemple, le filtrage peut être réalisé par des couches minces optiques déposées sur les deux faces de la fenêtre optique **14** ou en gravant des structures de type « *Moth-Eyes* », tel que décrit dans le document EP2613181, sur la partie de la paroi supérieure du boîtier **10** formant la fenêtre optique **14**.

En outre, les rayonnements infrarouges peuvent également être redirigés sur la face arrière de la membrane bolométrique au moyen d'un réflecteur **16** déposé sur le substrat **13** et sous la membrane bolométrique.

Dans le mode de réalisation de la figure 2, la couche de matériau getter **15a** du boîtier **10a** est déposée uniquement sur la fenêtre optique **14,** permettant ainsi d'obtenir un boîtier **10a,** dont les dimensions sont adaptées aux dimensions du composant optoélectronique **11.** En variante, tel qu'illustré sur la figure 3, la couche de matériau getter **15b** peut s'étendre également sur une paroi supérieure du boîtier **10b** ne formant pas la fenêtre optique **14** de sorte à augmenter la surface du matériau getter **15b.**

Dans ces deux modes de réalisation, contrairement aux réalisations classiques, une couche de matériau getter **15a, 15b** est déposée sur la fenêtre optique **14** pour capter les gaz présents dans l'enceinte **12** après activation du getter.

Conformément à l'invention, le getter **15a** présente une épaisseur $e_t$ supérieure à 60 nanomètres et une porosité P comprise entre 10% et 70%. L'épaisseur $e_t$ et la porosité P sont configurées de sorte à satisfaire la relation suivante :

$$(1 - \text{P}) * \text{e}_\text{t} < \frac{\lambda}{2\pi\text{k}}$$

avec λ correspondant à la longueur d'onde d'intérêt de la fenêtre optique **14,** et k correspondant au coefficient d'extinction du matériau de la couche de matériau getter **15a, 15b** pour la longueur d'onde d'intérêt.

Dans le cas où la fenêtre optique **14** couvre une plage de longueurs d'onde d'intérêt, typiquement pour la plage de longueurs d'onde comprise entre 8 et 14 micromètres, l'épaisseur $e_t$ et la porosité P sont configurées pour satisfaire à cette relation pour toutes les longueurs d'onde de la plage de la fenêtre optique **14.** Les pores peuvent être constitués de vide, d'air ou de tout autre matériau transparent dans les longueurs d'onde d'intérêt.

La couche de matériau getter **15a, 15b** peut être réalisée en zirconium (Zr), en titane (Ti), en vanadium (V), en hafnium (Hf), en niobium (Nb), en tantale (Ta), en cobalt (Co), en fer (Fe), en yttrium (Y), en baryum (Ba) ou en alliance de ces matériaux. De plus, de l'aluminium (Al), du nickel (Ni) et des terres rares telles que le chrome (Cr), le cérium (Ce), le césium (Cs) ou le lanthane (La) peuvent être ajoutés à ces métaux pour améliorer les caractéristiques de la couche de matériau getter **15a, 15b,** telles que la taille des grains, l'enthalpie libre de formation des oxydes ou l'activité catalytique pour le craquage des molécules gazeuses.

Pour obtenir la porosité recherchée, le dépôt du matériau getter **15a, 15b** peut être réalisé par évaporation ou pulvérisation sous incidence à partir d'un élément **30** d'évaporation ou de pulvérisation, tel qu'illustré sur la figure 4. Par exemple, l'élément **30** peut être constitué d'un creuset dans le cas d'un dépôt par évaporation.

Au sens de l'invention, un dépôt sous incidence correspond à un dépôt dans lequel l'angle d'incidence $\theta$ entre la fenêtre optique **14** et la normale **N** du flux généré **F** est supérieur à 10° par opposition aux procédés classiquement dans lesquels la surface de dépôt est coplanaire à la normale **N**. De préférence, l'angle d'incidence $\theta$ entre la fenêtre optique **14** et la normale **N** du flux généré **F** est compris entre 40° et 80° de sorte à utiliser les effets d'ombrage pour créer des motifs présentant des porosités élevées.

Pour structurer les porosités, il est également possible d'utiliser une rotation permanente ou intermittente de la fenêtre optique **14** lors du dépôt du matériau getter **15a, 15b.**

Ce procédé de réalisation permet ainsi d'obtenir un getter **15a, 15b** dont l'épaisseur $e_t$ et la porosité P satisfont l'équation :

$$(1 - P) * e_t < \frac{\lambda}{2\pi k}$$

Par exemple, avec un film getter de titane déposé par évaporation oblique avec rotation permanente à 5 tr/min sous incidence à 60° jusqu'à atteindre une épaisseur de 157 nm, une porosité de 52% a été obtenue.

Selon ce premier exemple, l'expression (1 - P) * $e_t$ représente une valeur de $7.54.10^{-8}$. Pour la longueur d'onde de 8 micromètres, le titane présente un coefficient d'extinction k de 14.8 en utilisant le modèle de Lorentz-Drude de 1998. L'expression $\frac{\lambda}{2\pi k}$ représente donc une valeur de $8.60.10^{-8}$. L'équation de l'invention est ainsi respectée car $7.54.10^{-8} < 8.60.10^{-8}$. Pour la longueur d'onde de 14 micromètres, le titane présente un coefficient d'extinction k de 24.0 en utilisant le modèle de Lorentz-Drude de 1998.

L'expression $\frac{\lambda}{2\pi k}$ représente donc une valeur de $9.28. 10^{-8}$ et l'équation de l'invention est également respectée car $7.54. 10^{-8} < 9.28.10^{-8}$.

Pour un second exemple, avec un film getter de titane déposé par évaporation oblique avec rotations intermittentes de 6 secondes toutes les 18 secondes sous incidence à 60° jusqu'à atteindre une épaisseur de 151 nm, une porosité de 60% a été obtenue.

Selon ce second exemple, l'expression (1 - P) * $e_t$ représente une valeur de $6.04.10^{-8}$. L'équation de l'invention est ainsi respectée pour les longueurs d'ondes entre 8 et 14 micromètres car $6.04.10^{-8} < 8.60.10^{-8}$ et $6.04.10^{-8} < 9.28.10^{-8}$.

L'invention permet ainsi de régler l'épaisseur et la porosité pour obtenir un getter efficace tout en limitant l'impact sur le signal optique. Il s'ensuit que l'invention permet de positionner un getter sur une fenêtre optique tout en permettant une transmission efficace du signal optique.

**Revendications**

1. Boîtier hermétique (10a, 10b), pour composant optoélectronique (11) ou pour dispositif MEMS, configuré pour former une enceinte (12) au sein de laquelle règne une faible pression ou le vide, ledit boîtier hermétique (10a, 10b) comportant :

   - une fenêtre optique (14) transparente pour au moins une longueur d'onde d'intérêt ($\lambda$) dudit composant optoélectronique (11) ou du dispositif MEMS ; et
   - une couche de matériau getter (15a, 15b) configurée pour capter des gaz présents dans ladite enceinte (12) et déposée sur ladite fenêtre optique (14) en regard de ladite enceinte (12) ;

   *caractérisé* **en ce que** la couche de matériau getter (15a, 15b) présente une épaisseur ($e_t$) supérieure à 60 nanomètres et une porosité (P) comprise entre 10% et 70% ; l'épaisseur ($e_t$) et la porosité (P) étant configurées de sorte à satisfaire la relation suivante :

   $$(1 - P) * e_t < \frac{\lambda}{2\pi k}$$

avec λ correspondant à ladite au moins une longueur d'onde d'intérêt de la fenêtre optique (14), et k correspondant au coefficient d'extinction du matériau de la couche de matériau getter (15a, 15b) pour ladite au moins une longueur d'onde d'intérêt de la fenêtre optique (14).

2. Boîtier hermétique selon la revendication 1, ***dans lequel*** la couche de matériau getter (15a, 15b) présente une base surmontée par un motif de structuration, l'épaisseur de ladite base étant supérieure à 60 nanomètres.

3. Boîtier hermétique selon la revendication 1 ou 2, ***dans lequel*** la couche de matériau getter (15a, 15b) est réalisée en zirconium (Zr), en titane (Ti), en vanadium (V), en hafnium (Hf), en niobium (Nb), en tantale (Ta), en cobalt (Co), en yttrium (Y), en baryum (Ba), en fer (Fe) ou en alliance de ces matériaux.

4. Boîtier hermétique selon la revendication 3, ***dans lequel*** la couche de matériau getter (15a, 15b) est réalisée en outre avec des terres rares ou de l'aluminium (Al), ou du nickel (Ni).

5. Composant optoélectronique ou dispositif MEMS ***caractérisé en ce qu'***il comporte un boîtier hermétique selon l'une des revendications 1 à 4.

6. Procédé de fabrication d'un composant optoélectronique ou d'un dispositif MEMS selon la revendication 5, ***caractérisé en ce qu'***il comporte une étape de dépôt par évaporation ou pulvérisation d'une couche de matériau getter (15a, 15b) réalisée sous incidence de ladite fenêtre optique (14) par rapport à un flux (F) généré par un élément (30) d'évaporation ou de pulvérisation de ladite couche de matériau getter.

7. Procédé de fabrication selon la revendication 6, ***dans lequel*** ladite étape de dépôt est réalisée alors que ladite fenêtre optique (14) est en rotation par rapport audit élément (30) d'évaporation ou de pulvérisation.

8. Procédé de fabrication selon la revendication 6 ou 7, ***dans lequel*** ladite étape de dépôt est réalisée avec un angle d'incidence (θ) compris entre 40 et 80° entre ladite fenêtre optique (14) et la normale (N) au flux généré (F) par ledit élément (30) d'évaporation ou de pulvérisation.

**Patentansprüche**

1. Hermetisch dichtes Gehäuse (10a, 10b) für optoelektronisches Bauteil (11) oder für Mems - Element, konfiguriert zur Bildung eines Gehäuses (12), in dem ein geringer Druck oder ein Vakuum herrscht, dieses hermetisch dichte Gehäuse (10a, 10b) enthält:

- ein optisches Fenster (14), durchlässig gegenüber mindestens einer gewünschten Wellenlänge (λ) dieses optoelektronischen Bauteils (11) oder des MEMS-Elementes; sowie
- eine Schicht Getter-Material (15a, 15b), konfiguriert zum Auffangen der in diesem Gehäuse (12) vorhandenen, auf diesem optischen Fenster (14) gegenüber diesem Gehäuse (12) abgeschiedenen Gase;

***dadurch gekennzeichnet, dass*** die Schicht Getter-Material (15a, 15b) eine Dicke (et) von mehr als 60 Nanometern und eine Porosität (P) zwischen 10% und 70% aufweist; die Dicker (et) und die Porosität (P) sind dabei so konfiguriert, dass sie die folgende Gleichung erfüllen:

$$(1 - P) * e_t < \frac{\lambda}{2\pi k}$$

mit λ entsprechend dieser mindestens einen gewünschten Wellenlänge des optischen Fensters (14), und k entsprechend dem Extinktionskoeffizient des Materials der Getter-Materialschicht (15a, 15b) für diese mindestens eine gewünschte Wellenlänge des optischen Fensters (14).

2. Hermetisch dichtes Gehäuse nach Anspruch 1, ***in dem*** die Schicht aus Getter-Material (15a, 15b) eine Basis aufweist, über der ein Strukturmotiv liegt, die Dicke dieser Basis ist dabei größer als 60 Nanometer.

3. Hermetisch dichtes Gehäuse nach Anspruch 1 oder 2, ***bei dem*** die Schicht aus Getter-Material (15a, 15b) aus Zirkonium (Zr), Titan (Ti), Vanadium (V), Hafnium (Hf), Niobium (Nb), Tantal (Ta), Kobalt (Co), Yttrium (Y), Baryum (Ba), Eisen (Fe) oder Legierungen dieser Materialien ausgeführt wird.

4. Hermetisch dichtes Gehäuse nach Anspruch 3, ***bei dem*** die Schicht aus Getter-Material (15a, 15b) außerdem aus seltenen Erden oder Aluminium (Al), oder Nickel (Ni) ausgeführt wird.

5. Optoelektronisches Bauteil oder MEMS-Element, ***dadurch gekennzeichnet, dass*** es ein hermetisch dichtes Gehäuse nach einem der Ansprüche 1 bis 4 enthält.

6. Verfahren zur Herstellung eines optoelektronischen Bauteils oder eines MEMS-Elementes nach Anspruch 5, ***dadurch gekennzeichnet, dass*** es einen Schritt der Abscheidung durch Verdampfen oder Zerstäuben einer Getter-Materialschicht (15a, 15b) enthält, ausgeführt unter der Einwirkung dieses optischen Fensters (14), bezogen auf einen Fluss (F), erzeugt durch ein Verdampfungs- oder Zerstäubungselement (30) dieser Getter-Materialschicht

7. Herstellungsverfahren nach Anspruch 6, *bei dem* dieser Abscheidungsschritt ausgeführt wird, während sich das erwähnte optische Fenster (14), bezogen auf dieses Verdampfungs- oder Zerstäubungselement (30), dreht

8. Herstellungsverfahren nach Anspruch 6 oder 7, *bei dem* dieser Abscheidungsschritt ausgeführt wird mit einem Einfallswinkel (0) zwischen 40 und 80° zwischen dem erwähnten optischen Fenster (14) und der Normalen (N) zum Fluss (F), der von diesem Verdampfungs- oder Zerstäubungselement (30) erzeugt wird.

**Claims**

1. A hermetic housing (10a, 10b), for an optoelectronic component (11) or for a MEMS device configured to form an enclosure (12) within which a low pressure or vacuum prevails, said hermetic housing (10a, 10b) comprising:

   - an optical window (14) transparent for at least one wavelength of interest ($\lambda$) of said optoelectronic component (11) or of the MEMS device; and
   - a layer of a getter material (15a, 15b) configured to capture gases present in said enclosure (12) and deposited on said optical window (14) opposite said enclosure (12);

   *characterized* **in that** the layer of getter material (15a, 15b) has a thickness ($e_t$) greater than 60 nanometers and a porosity (P) in the range from 10% to 70%; the thickness ($e_t$) and the porosity (P) being configured to satisfy the following relation:

   $$(1 - P) * e_t < \frac{\lambda}{2\pi k}$$

   with $\lambda$ corresponding to said at least one wavelength of interest of the optical window (14), and k corresponding to the extinction coefficient of the material of the layer of getter material (15a, 15b) for said at least one wavelength of interest of the optical window (14).

2. Hermetic housing according to claim 1, *wherein* the layer of getter material (15a, 15b) has a base topped with a structuring pattern, the thickness of said base being greater than 60 nanometers.

3. Hermetic housing according to claim 1 or 2, *wherein* the layer of getter material (15a, 15b) is made of zirconium (Zr), of titanium (Ti), of vanadium (V), of hafnium (Hf), of niobium (Nb), of tantalum (Ta), of cobalt (Co), of yttrium (Y), of barium (Ba), of iron (Fe), or of an alloy of these materials.

4. Hermetic housing according to claim 3, *wherein* the layer of getter material (15a, 15b) is further formed with rare earths or aluminum (Al), or nickel (Ni).

5. Optoelectronic component or MEMS device, *characterized in that* it comprises a hermetic housing according to any of claims 1 to 4.

6. Method of manufacturing an optoelectronic component or a MEMS device according to claim 5, *characterized in that* it comprises a step of deposition by evaporation or sputtering of a layer of a getter material (15a, 15b) formed under incidence of said optical window (14) with respect to a flux (F) generated by an evaporation or sputtering element (30) of said layer of getter material.

7. Manufacturing method according to claim 6, *wherein* said deposition step is carried out while said optical window (14) is rotating with respect to said evaporation or sputtering element (30).

8. Manufacturing method according to claim 6 or 7, *wherein* said deposition step is carried out with an incidence angle ($\Theta$) in the range from 40 to 80° between said optical window (14) and the normal (N) to the flux (F) generated by said evaporation or sputtering element (30).

## Fig. 1
## Etat de la technique

## Fig. 2

## Fig. 3

14

θ

N

F

30

Fig. 4

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 7998319 B
- US 6897551 B
- US 8395229 B
- US 20140175590 A
- EP 2613181 A
- US 7789949 B
- US 20150014854 A